(19)

Europäisches Patentamt

European Patent Office

Office européen des brevets

(11)  **EP 3 598 862 B1**

(12)  **EUROPEAN PATENT SPECIFICATION**

(45) Date of publication and mention
of the grant of the patent:
**07.05.2025   Bulletin 2025/19**

(21) Application number: **18766871.0**

(22) Date of filing: **13.03.2018**

(51) International Patent Classification (IPC):
*H05K 9/00* (2006.01)      *H01F 1/11* (2006.01)
*H01F 1/03* (2006.01)      *C01G 49/00* (2006.01)
*C01G 49/06* (2006.01)     *B32B 7/02* (2019.01)
*B32B 25/02* (2006.01)     *B32B 3/28* (2006.01)
*B32B 7/12* (2006.01)      *B32B 15/02* (2006.01)
*B32B 15/06* (2006.01)     *B32B 15/20* (2006.01)
*B32B 25/08* (2006.01)     *B32B 25/12* (2006.01)
*B32B 25/16* (2006.01)     *B32B 25/18* (2006.01)
*B32B 25/20* (2006.01)     *H01F 1/113* (2006.01)

(52) Cooperative Patent Classification (CPC):
**H05K 9/0086; B32B 3/28; B32B 7/12; B32B 15/02;
B32B 15/06; B32B 15/20; B32B 25/02;
B32B 25/08; B32B 25/12; B32B 25/16;
B32B 25/18; B32B 25/20; H01F 1/113;
H05K 9/0083;** B32B 2250/02;          (Cont.)

(86) International application number:
**PCT/JP2018/009762**

(87) International publication number:
**WO 2018/168859 (20.09.2018 Gazette 2018/38)**

(54) **ELECTROMAGNETIC WAVE ABSORPTION SHEET**

ELEKTROMAGNETISCHE WELLENABSORPTIONSSCHICHT

FEUILLE D'ABSORPTION D'ONDE ÉLECTROMAGNÉTIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **13.03.2017   JP 2017047746**

(43) Date of publication of application:
**22.01.2020   Bulletin 2020/04**

(73) Proprietor: **Maxell, Ltd.**
**Kyoto 618-8525 (JP)**

(72) Inventors:
• **HIROI Toshio**
**Oyamazaki-cho**
**Otokuni-gun**
**Kyoto 618-8525 (JP)**

• **FUJITA Masao**
**Oyamazaki-cho**
**Otokuni-gun**
**Kyoto 618-8525 (JP)**

(74) Representative: **Diehl & Partner**
**Patent- und Rechtsanwaltskanzlei mbB**
**Erika-Mann-Straße 9**
**80636 München (DE)**

(56) References cited:
WO-A1-2012/133419      JP-A- 2001 189 586
JP-A- 2002 198 685      JP-A- 2002 271 084
JP-A- 2007 019 287      JP-A- 2007 019 287
JP-A- 2008 277 726      JP-A- 2008 277 726
JP-A- 2017 184 106      US-A1- 2013 140 076
US-A1- 2016 113 162

(52) Cooperative Patent Classification (CPC): (Cont.)
B32B 2255/205; B32B 2260/025; B32B 2260/048;
B32B 2264/102; B32B 2307/202; B32B 2307/204;
B32B 2307/212; B32B 2307/714; B32B 2307/732;
B32B 2457/00

## Description

Technical Field

The present disclosure relates to an electromagnetic-wave absorbing sheet for absorbing electromagnetic waves, and in particular relates to an electromagnetic-wave absorbing sheet that includes an electromagnetic-wave absorbing material for absorbing electromagnetic waves through magnetic resonance to absorb electromagnetic waves of high frequencies in a frequency band in or above a millimeter-wave band, and that has flexibility.

Background Art

Electromagnetic-wave absorbing sheets for absorbing electromagnetic waves have been used to avoid the influence of leaked electromagnetic waves emitted to the outside from an electric circuit or the like and the influence of undesirably reflected electromagnetic waves.

Recently, research on techniques utilizing high frequency electromagnetic waves, including centimeter waves having a frequency of several gigahertz (GHz), millimeter waves having a frequency of 30 GHz to 300 GHz, and electromagnetic waves having an even higher frequency of one terahertz (THz) as electromagnetic waves in a high frequency band above the millimeter-wave band, has proceeded for mobile communications such as mobile phones, wireless LAN and electric toll collection system (ETC).

In response to the trend of techniques utilizing electromagnetic waves of higher frequencies, there is growing demand for electromagnetic-wave absorbers and electromagnetic-wave absorbing sheets for absorbing unnecessary electromagnetic waves to absorb electromagnetic waves in higher frequency bands from the gigahertz band to the terahertz band.

As electromagnetic-wave absorbers for absorbing electromagnetic waves in a high frequency band in or above the millimeter-wave band, Patent Document 1 proposes an electromagnetic-wave absorber that has a packed structure of particles having epsilon iron oxide ($\varepsilon$-$Fe_2O_3$) crystal in the magnetic phase, the epsilon iron oxide exhibiting an electromagnetic-wave absorbing capacity in a range from 25 to 100 GHz (see Patent Document 1). Patent Document 2 proposes a sheet-shaped oriented body obtained by mixing and kneading fine epsilon iron oxide particles with a binder, and applying a magnetic field to the mixture from the outside during dry curing of the binder to improve the magnetic field orientation of the epsilon iron oxide particles (see Patent Document 2).

Furthermore, Patent Document 3 proposes an elastic electromagnetic-wave absorbing sheet that can absorb centimeter waves, wherein carbon nanotubes are dispersed in silicone rubber (see Patent Document 3). Patent Document 4 discloses a cover film including a conductive adhesive layer, an electromagnetic shielding layer formed on the conductive adhesive layer, and an insulating layer formed on the electromagnetic shielding layer. The electromagnetic shielding layer has a thickness of from 0.01 to 25 $\mu$m, such that the cover film can shield electromagnetic interference through the thinner interposed electromagnetic shielding layer. As a conventional electromagnetic wave absorber, Patent Document 5 discloses an electromagnetic-wave absorbing sheet that includes a magnetic loss sheet and a dielectric loss sheet, which are stacked on top of each other. The magnetic loss sheet may be a sheet obtained by dispersing and mixing a soft magnetic material in an insulating material such as rubber. The dielectric loss sheet may be a sheet containing 10 to 70% by volume of a conductive material with an electrical conductivity of $5 \times 10^{-6}$ S/cm or more and $1 \times 10^3$ S/cm or less and an insulating material. The electromagnetic-wave absorbing sheet can absorb electromagnetic waves in the range of 100 MHz to several 100 GHz.

Prior Art Documents

Patent Documents

Patent Document 1: JP 2008-60484 A
Patent Document 2: JP 2016-135737 A
Patent Document 3: JP 2011-233834 A
Patent Document 4: US 2016/113162 A1
Patent Document 5: JP 2007-019287 A

Disclosure of Invention

Problem to be solved by the Invention

When leaked electromagnetic waves from a generating source that generates electromagnetic waves are to be shielded, an electromagnetic-wave absorbing material needs to be arranged in a housing or the like covering the target circuit component. However, in particular, if the shape of the arrangement location is not flat, it is more convenient and preferable to use an electromagnetic-wave absorbing sheet that has flexibility, rather than using an electromagnetic absorber that is solid.

However, a sheet-shaped electromagnetic-wave absorbing sheet having sufficient flexibility has not been realized as an electromagnetic-wave absorbing member that can absorb electromagnetic waves with frequencies greater than or equal to several tens of GHz, which is the millimeter-wave band.

In order to solve the problems of the conventional technique, the present disclosure aims to realize an electromagnetic-wave absorbing sheet that can favorably absorb electromagnetic waves having high frequencies in and above the millimeter-wave band, and that has sufficient flexibility.

Means for Solving Problem

In order to solve the above problem, an electromagnetic-wave absorbing sheet according to claim 1 is provided.

Effects of the Invention

The electromagnetic-wave absorbing sheet disclosed in the present application has an electromagnetic-wave absorbing layer in which magnetic iron oxide that magnetically resonates in a high-frequency band in or above the millimeter-wave band is included as an electromagnetic-wave absorbing material, and due to a non-magnetic dielectric layer being arranged on the back surface of the electromagnetic-wave absorbing layer, electromagnetic waves in a high-frequency band of several tens of GHz or more can be converted into heat and absorbed, and high-level impedance matching with respect to the input impedance can be realized. Also, since the electromagnetic-wave absorbing sheet is constituted by an electromagnetic-wave absorbing layer in which a rubber binder is used, and a dielectric layer having flexibility, it is possible to realize an electromagnetic-wave absorbing sheet that has high flexibility overall, and has high shape correspondence with the arrangement location.

Brief Description of Drawings

[FIG. 1] FIG. 1 is a cross-sectional view for illustrating a first configuration of an electromagnetic-wave absorbing sheet according to an embodiment.

[FIG. 2] FIG. 2 is a diagram illustrating electromagnetic-wave absorbing properties of epsilon iron oxide obtained by substituting a portion of Fe sites.

[FIG. 3] FIG. 3 shows model diagrams illustrating electric characteristics of an electromagnetic-wave absorbing sheet including a non-magnetic dielectric layer on a back surface of an electromagnetic-wave absorbing layer. FIG. 3(a) is a block diagram illustrating a first configuration of the electromagnetic-wave absorbing sheet according to the present embodiment. FIG. 3(b) is a diagram showing a first configuration of the electromagnetic-wave absorbing sheet according to the present embodiment as an equivalence circuit.

[FIG. 4] FIG. 4 is a cross-sectional view for illustrating a second configuration of an electromagnetic-wave absorbing sheet according to an embodiment.

[FIG. 5] FIG. 5 is a diagram showing changes in an electromagnetic-wave absorbing property caused by differences in the permittivities of dielectric layers of electromagnetic-wave absorbing sheets according to an embodiment.

[FIG. 6] FIG. 6 is a second diagram showing changes in an electromagnetic-wave absorbing property caused by differences in the permittivities of dielectric layers of electromagnetic-wave absorbing sheets according to an embodiment.

[FIG. 7] FIG. 7 is a diagram showing changes in an electromagnetic-wave absorbing property caused by differences in thicknesses of dielectric layers of electromagnetic-wave absorbing sheets according to an embodiment.

[FIG. 8] FIG. 8 is a diagram showing changes in an electromagnetic-wave absorbing property in the second configuration of the electromagnetic-wave absorbing sheet according to the embodiment.

[FIG. 9] FIG. 9 is a diagram showing changes in an electromagnetic-wave absorbing property caused by differences in the thicknesses of dielectric layers in the case of using strontium ferrite as magnetic iron oxide in an electromagnetic-wave absorbing sheet according to an embodiment.

[FIG. 10] FIG. 10 is a diagram showing changes in an electromagnetic-wave absorbing property in a case of using strontium ferrite as the magnetic iron oxide in the second configuration of the electromagnetic-wave absorbing sheet according to the embodiment.

Description of the Invention

The electromagnetic-wave absorbing sheet disclosed in the present application includes an electromagnetic-wave absorbing layer that includes a particulate electromagnetic-wave absorbing material and a rubber binder; and a dielectric layer arranged on a back surface of the electromagnetic-wave absorbing layer, wherein the electromagnetic-wave absorbing material is magnetic iron oxide that magnetically resonates in a frequency band in or above a millimeter-wave band, and the dielectric layer is non-magnetic and has flexibility, a real part of a complex relative permittivity of the dielectric layer is 2 or more and 6 or less, and the dielectric layer has a thickness of 10 $\mu$m or more and 100 $\mu$m or less.

By doing so, the electromagnetic-wave absorbing sheet disclosed in the present application can absorb electromagnetic waves in a high-frequency band of 30 GHz or more, which is the millimeter-wave band, through magnetic resonance of the electromagnetic-wave absorbing material, and can easily match the overall input impedance of the electromagnetic-wave absorbing sheet with the impedance in the air using the dielectric layer formed on the back surface of the electromagnetic-wave absorbing layer. Also, the electromagnetic-wave absorbing layer, in which a rubber binder is used, and the dielectric layer have flexibility, the electromagnetic-wave absorbing sheet has flexibility overall, and therefore ease of handling the electromagnetic-wave absorbing sheet improves, and in particular, it is easy to arrange the electromagnetic-wave absorbing sheet on a surface that is curved in a complex manner.

In the electromagnetic-wave absorbing sheet disclosed in the present application, it is preferable that a reflective layer that reflects electromagnetic waves that have passed through the electromagnetic-wave absorbing layer and the dielectric layer is formed on the back surface of the dielectric layer. By doing so, it is possible to reliably perform shielding from and absorption of electromagnetic waves in a high-frequency band in or above the millimeter-wave band, and it is possible to realize a so-called reflective electromagnetic-wave absorbing sheet that has flexibility.

In the electromagnetic-wave absorbing sheet disclosed in the present application, it is preferable that the electromagnetic-wave absorbing material is epsilon iron oxide or strontium ferrite. Epsilon iron oxide and strontium ferrite, which serve as electromagnetic-wave absorbers that absorb electromagnetic waves with frequencies higher than 30 GHz, are used as the electromagnetic-wave absorbing material, whereby an electromagnetic-wave absorbing sheet that absorbs electromagnetic waves with high frequencies can be realized.

Also, it is preferable that the electromagnetic-wave absorbing material is epsilon iron oxide, and a portion of Fe sites of the epsilon iron oxide are substituted with trivalent metal atoms. By doing so, it is possible to realize an electromagnetic-wave absorbing sheet that absorbs electromagnetic waves in a desired frequency band by utilizing the properties of epsilon iron oxide, whose magnetic resonance frequency is different depending on the material with which the Fe sites are substituted.

Also, a configuration can be employed in which the dielectric layer is formed as a stacked body with two or more layers. By doing so, it is possible to easily perform adjustment of the overall thickness and input impedance of the electromagnetic-wave absorbing sheet.

Furthermore, it is preferable that the dielectric layer has adhesiveness. By doing so, it is possible to functionally utilize the dielectric layer to adhere the electromagnetic-wave absorbing sheet, and thus a stacked body obtained by stacking the electromagnetic-wave absorbing layer and the dielectric layer can be easily adhered to the surface of another base, which is the arrangement location of the electromagnetic-wave absorbing sheet, or the reflective layer, which is provided as needed.

Note that "electric waves" can be understood in a wider sense as a type of electromagnetic waves, and therefore in the present specification, the term "electromagnetic waves" is used, such as referring to an electric-wave absorbing sheet as an electromagnetic-wave absorbing sheet.

Hereinafter, an electromagnetic-wave absorbing sheet disclosed in the present application will be described with reference to the drawings.

(Embodiments)

(First Configuration Example)

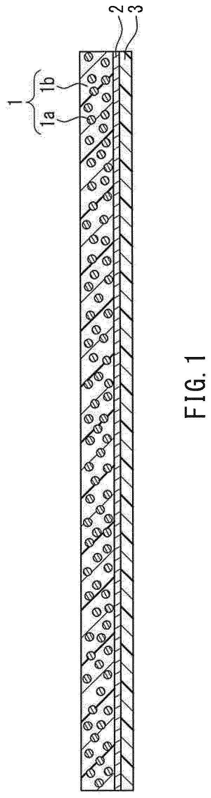

FIG. 1 is a cross-sectional view for illustrating a first configuration of an electromagnetic-wave absorbing sheet according to an embodiment of the present application.

The embodiment shown in FIG. 1 is an exemplary configuration of a so-called reflective electromagnetic-wave absorbing sheet in which a reflective layer is included on a back surface side of the electromagnetic-wave absorbing sheet.

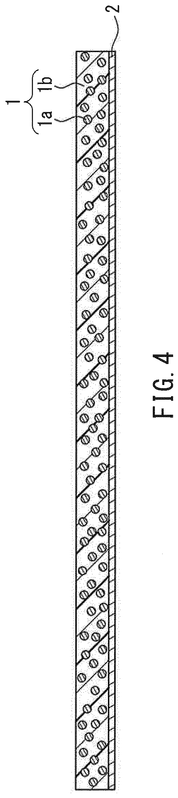

Note that FIG. 1 and FIG. 4, which shows an exemplary configuration of a later-described transmissive electromagnetic-wave absorbing sheet, are diagrams that have been drawn in order to facilitate comprehension of the configuration of the electromagnetic-wave absorbing sheet according to the present embodiment, and the sizes and thicknesses of the members shown in the drawings are not shown in conformity with reality.

Also, hereinafter in the present specification, the surface on the side on which the electromagnetic waves to be absorbed are incident on the electromagnetic-wave absorbing sheet will be referred to as the front surface side of the electromagnetic-wave absorbing sheet. Furthermore, the surface on the side opposite to the front surface side, that is, the surface on the side on which the electromagnetic waves are emitted in the case where the electromagnetic-wave absorbing sheet is transmissive, will be referred to as the back surface side of the electromagnetic-wave absorbing sheet.

As shown in FIG. 1, a reflective electromagnetic-wave absorbing sheet that is described as an example of a first configuration of the present embodiment includes an electromagnetic-wave absorbing layer 1, an adhesive layer 2 serving as a dielectric layer, and a reflective layer 3 that are sequentially stacked starting from the front surface side of the electromagnetic-wave absorbing sheet, which is the upper side in FIG. 1.

[Electromagnetic-Wave Absorbing Layer]

The electromagnetic-wave absorbing sheet includes the electromagnetic-wave absorbing layer 1, which includes magnetic iron oxide powder 1a, which is a particulate electromagnetic-wave absorbing material, and a rubber binder 1b.

In the electromagnetic-wave absorbing sheet of the present embodiment, various types of rubber materials are used in the binder 1b included in the electromagnetic-wave absorbing layer 1. For this reason, in particular, it is possible to obtain an electromagnetic-wave absorbing sheet that easily expands and contracts in the in-plane direction of the electromagnetic-wave absorbing sheet. Note that with the electromagnetic-wave absorbing sheet according to the present embodiment, the electromagnetic-wave absorbing layer is formed with the magnetic iron oxide powder 1a being included in the rubber binder 1b, and therefore the electromagnetic-wave absorbing sheet is highly elastic and highly flexible at the same time, and thus it is possible to roll up the electromagnetic-wave absorbing sheet when handling the electromagnetic-wave absorbing sheet, and it is possible to easily arrange the electromagnetic-wave absorbing sheet along a curved surface.

In the electromagnetic-wave absorbing sheet of this embodiment, the particulate electromagnetic-wave absorbing material may be magnetic iron oxide powder, including epsilon iron oxide magnetic powder, barium ferrite magnetic powder, and strontium ferrite magnetic powder. Among these, epsilon iron oxide is particularly preferable as the electromagnetic-wave absorbing material because the electrons of the iron atoms have a high precession frequency when spinning, and epsilon iron oxide has a high effect of absorbing electromagnetic waves with frequencies of 30 to 300 GHz, which is the millimeter-wave band, and higher.

The epsilon phase of epsilon iron oxide ($\varepsilon$-Fe$_2$O$_3$) is a phase that appears between the alpha phase ($\alpha$-Fe$_2$O$_3$) and the gamma phase ($\gamma$-Fe$_2$O$_3$) in ferric oxide (Fe$_2$O$_3$). Epsilon iron oxide is a magnetic material that can be obtained in a single phase state through a nanoparticle synthesis method in which a reverse micelle method and a sol-gel method are combined.

Epsilon iron oxide is a fine particle of several nm to several tens of nm but has a coercive force of about 20 kOe at room temperature, which is the largest coercive force among metal oxides. Furthermore, the natural magnetic resonance due to a gyromagnetic effect obtained based on the precession occurs in a frequency band of several tens of GHz or higher, which is a so-called millimeter-wave band.

In epsilon iron oxide, by substituting a portion of the Fe sites of the crystal with a trivalent metal element such as aluminum (Al), gallium (Ga), rhodium (Rh), or indium (In), it is possible to change the magnetic resonance frequency, that is, the frequency of electromagnetic waves that are absorbed when epsilon iron oxide is used as the electromagnetic-wave absorbing material.

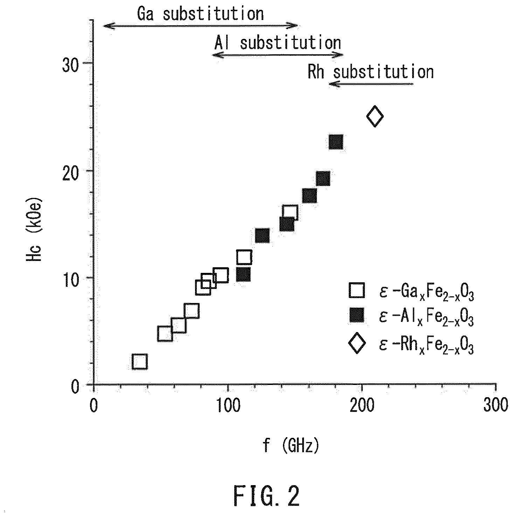

FIG. 2 shows a relationship between a coercive force Hc and a natural resonance frequency f of epsilon iron oxide when the metal element with which the Fe sites are substituted is changed. Note that the natural resonance frequency f coincides with the frequency of electromagnetic waves that are absorbed.

FIG. 2 indicates that epsilon iron oxides in which a portion of the Fe sites are substituted have different natural resonance frequencies depending on the type of the substituted metal element and the substitution amount. Moreover, the coercive force of epsilon iron oxide increases in keeping with the natural resonance frequency.

More specifically, epsilon iron oxide substituted with gallium ($\varepsilon$-Ga$_x$Fe$_{2-x}$O$_3$) has an absorption peak in a frequency band of about 30 GHz to 150 GHz as a result of adjusting the substitution amount "x". Epsilon iron oxide substituted with aluminum ($\varepsilon$-Al$_x$Fe$_{2-x}$O$_3$) has an absorption peak in a frequency band of about 100 GHz to 190 GHz as a result of adjusting the substitution amount "x". Therefore, the frequency of electromagnetic waves that are absorbed can be set to a desired value by deciding on the type of the element with which the Fe sites of the epsilon iron oxide are substituted and adjusting the substitution amount of Fe so that the natural resonance frequency of the epsilon iron oxide will be a desired frequency to be absorbed by the electromagnetic-wave absorbing sheet. Furthermore, in the case of using epsilon iron oxide substituted with rhodium ($\varepsilon$-Rh$_x$Fe$_{2-x}$O$_3$), it is possible to shift the frequency band of electromagnetic waves to be absorbed in an even higher direction of 180 GHz or higher.

Epsilon iron oxide can be easily obtained since it is commercially available along with epsilon iron oxide in which a portion of Fe sites have been subjected to metal substitution. Note that epsilon iron oxide powder has an average particle diameter of approximately 30 nm and has an approximately spherical or short rod shape (bar shape).

Also, magnetic powder of strontium ferrite can be preferably used as the electromagnetic-wave absorbing material. It is preferable that magnetoplumbite strontium ferrite magnetic powder is used as the strontium ferrite magnetic powder. Specifically, when magnetoplumbite strontium ferrite magnetic powder expressed by the compositional formula $SrFe_{(12-x)}Al_xO_{19}$ (x: 1.0 to 2.2) is used, electromagnetic waves can be effectively absorbed in the band of 76 GHz $\pm$ 10 GHz. In particular, it is preferable to use magnetic powder with a peak particle diameter in a laser diffraction/scattering grain size distribution of 10 $\mu$m or more, from the viewpoint of the electromagnetic-wave absorbing property.

Various kinds of rubber materials can be used as the rubber binder 1b constituting the electromagnetic-wave absorbing layer 1. Examples of the rubber materials include natural rubber (NR), isoprene rubber (IR), butadiene rubber (BR), styrene-butadiene rubber (SBR), butyl rubber (IIR), nitrile rubber (NBR), ethylene-propylene rubber (EPDM), chloroprene rubber (CR), acrylic rubber (ACM), chlorosulfonated polyethylene rubber (CSR), urethane rubber (PUR), silicone rubber (Q), fluororubber (FKM), ethylene-vinyl acetate rubber (EVA), epichlorohydrin rubber (CO), and polysulfide rubber (T).

Among these rubber materials, acrylic rubber and silicone rubber are preferable due to having high heat resistance. Acrylic rubber offers excellent oil resistance even in high temperature environments while being relatively inexpensive and cost-effective. Silicone rubber offers not only high heat resistance but also high cold resistance. Moreover, the physical properties of silicone rubber are the most temperature-independent among synthetic rubbers, and silicone rubber offers excellent solvent resistance, ozone resistance, and weather resistance. Furthermore, silicone rubber has excellent electrical insulation properties while being physically stable in a wide temperature range and a wide frequency region.

In the electromagnetic-wave absorbing layer 1 of the electromagnetic-wave absorbing sheet according to this embodiment, when epsilon iron oxide powder is used as the electromagnetic-wave absorbing material 1a, for example, it is important to favorably disperse the epsilon iron oxide powder in the binder 1b during the formation of the electromagnetic-wave absorbing layer 1, since the epsilon iron oxide powder is a fine nanoparticle having a particle diameter of several nm to several tens of nm as described above. For this reason, it is preferable to use a polymeric dispersant or a silane coupling agent. More specifically, "KEM-3103" (product name) manufactured by Shin-Etsu Chemical Co., Ltd. or the like can be used.

Note that in one example, in the composition of the electromagnetic-wave absorbing layer 1, the content of the rubber binder can be set to 2 to 50 parts and the content of the dispersant can be set to 0.1 to 15 parts, with respect to 100 parts of epsilon iron oxide powder. If the content of the rubber binder is less than two parts, the magnetic iron oxide cannot be favorably dispersed. Also, the shape of the electromagnetic-wave absorbing sheet can no longer be maintained, and the elongation of the electromagnetic-wave absorbing sheet is more difficult to obtain. If the content of the rubber binder exceeds 50 parts, the elongation of the electromagnetic-wave absorbing sheet can be obtained, but the volume content of the magnetic iron oxide in the electromagnetic-wave absorbing sheet is lowered and the permeability decreases, which lessens the electromagnetic-wave absorption effect.

If the content of the dispersant is less than 0.1 parts, the magnetic iron oxide cannot be favorably dispersed in the rubber binder. If the content of the dispersant exceeds 15 parts, the effect of favorably dispersing the magnetic iron oxide becomes saturated, the volume content of the magnetic iron oxide in the electromagnetic-wave absorbing sheet is lowered, and the permeability decreases, which lessens the electromagnetic-wave absorption effect.

[Method for Manufacturing Electromagnetic-Wave Absorbing Layer]

Here, a method for manufacturing the electromagnetic-wave absorbing layer 1 of the electromagnetic-wave absorbing sheet according to the present embodiment will be described. With the electromagnetic-wave absorbing sheet of the present embodiment, the electromagnetic-wave absorbing layer 1 is formed by producing a magnetic compound that includes at least a magnetic iron oxide powder and a rubber binder, molding the magnetic compound at a predetermined thickness, and crosslinking the resulting compound.

First, the magnetic compound is produced.

The magnetic compound can be obtained by mixing and kneading the epsilon iron oxide powder and the dispersant with the rubber binder. As an example, the kneaded mixture is obtained through mixing and kneading with a pressurizing batch kneader. Note that at this time, a cross-linking agent can be mixed in according to need.

The obtained magnetic compound is crosslinked and molded into a sheet shape at a temperature of 150 degrees (hereinafter, temperature is in Celsius) using, as one example, a hydraulic press or the like.

Thereafter, a secondary cross-linking process can be implemented at a temperature of 170°C in a thermostatic tank, and thus the electromagnetic-wave absorbing layer can be formed.

[Dielectric Layer]

As shown in FIG. 1, in the electromagnetic-wave absorbing sheet according to the present embodiment, an adhesive layer 2 serving as a non-magnetic dielectric layer is formed on the back surface side of the electromagnetic-wave absorbing layer 1.

In a first configuration of the electromagnetic-wave absorbing sheet according to the present embodiment, a reflective layer is arranged on the back surface side of the electromagnetic-wave absorbing layer via a dielectric layer. In this case, in order to realize a predetermined input impedance in the electromagnetic-wave absorbing sheet, it is important to adhere an electromagnetic-wave absorbing layer with a predetermined thickness and a dielectric layer with a predetermined thickness, and the dielectric layer and a reflective layer, in a state of being in close contact with each other. This is because if there is a gap between layers, the gap portions will have a permittivity, and the overall input impedance of the electromagnetic-wave absorbing sheet will not be a predetermined input impedance. For this reason, the sheet-shaped adhesive layer 2, which has an adhesion function, is used as a dielectric layer, and thereby the stacked structure formed due to the electromagnetic-wave absorbing layer 1, the dielectric layer (adhesive layer 2), and the reflective layer 3 being in close contact with each other can be easily realized.

With the electromagnetic-wave absorbing sheet according to the present embodiment, the dielectric layer has flexibility itself, and includes the condition that a real part $\varepsilon'$ of the complex relative permittivity is 2 or more and 6 or less, and the thickness of the dielectric layer is 10 $\mu$m or more and 100 $\mu$m or less.

In order to obtain a favorable electromagnetic-wave absorbing property in the electromagnetic-wave absorbing sheet in which the reflective layer is arranged, the input impedance of the electromagnetic-wave absorbing sheet needs to be matched with the impedance in the air as described later. Even if the real part $\varepsilon'$ of the complex relative permittivity is 2 or more and 6 or less, if the thickness of the dielectric layer is less than 10 $\mu$m or greater than 100 $\mu$m, the effect of increasing the electromagnetic wave attenuation amount is not obtained since the overall input impedance of the electromagnetic-wave absorbing sheet, which is a combination of the impedance of the electromagnetic-wave absorbing layer and the impedance of the dielectric layer, cannot be matched with the impedance in the air. Also, even if the thickness of the dielectric layer is 10 $\mu$m or more and 100 $\mu$m or less, if the real part $\varepsilon'$ of the complex relative permittivity is less than 2 or greater than 6, the effect of increasing the electromagnetic wave attenuation amount is similarly not obtained since the overall input impedance of the electromagnetic-wave absorbing sheet cannot be matched with the impedance in the air.

In the adhesive layer 2 having flexibility, it is possible to use a rubber-based adhesive agent such as a butyl rubber-based adhesive agent, an acrylic rubber-based adhesive agent, or a silicone rubber-based adhesive agent, which have low glass transition temperatures (Tg), or various types of adhesive agents that are not rubber-based, and in order to adjust the permittivity, a high-permittivity ceramic powder such as barium titanate or titanium dioxide can be mixed in. Also, a tackifier or a crosslinking agent, which are used to adjust the tackiness, can be included in a general adhesive layer.

Note that as described above, in the electromagnetic-wave absorbing sheet according to the present embodiment, the electromagnetic-wave absorbing layer 1 is formed as a film including a particulate electromagnetic-wave absorbing material, and therefore sometimes the electromagnetic-wave absorbing sheet cannot have a flexibility of a predetermined magnitude or more due to being limited by the content, particle shape, size, or the like of the electromagnetic-wave absorbing material. In contrast to this, the adhesive layer 2 can be relatively easily realized as a layer having a large flexibility by mainly using a rubber-based or resin-based adhesive layer such as that described above. For this reason, when forming the adhesive layer 2, by devising the material, forming state, or the like, the adhesive layer 2 is formed as a layer having a flexibility of at least a degree according to which the elastic deformation of the electromagnetic-wave absorbing layer 1 is not hindered.

[Reflective Layer]

Any metal layer formed in close contact with the back surface side of the adhesive layer 2 can be used as the reflective layer 3. However, since the electromagnetic-wave absorbing layer 1 and the adhesive layer 2 of the electromagnetic-wave absorbing sheet of the present embodiment both have flexibility and the electromagnetic-wave absorbing sheet has flexibility overall, a metal foil, a metal-deposited film, a mesh-shaped conductor, silver nano-wires (Ag-NW), a conductive polymeric film, or the like is used as the reflective layer 3, and thus when the electromagnetic-wave absorbing layer 1 and the adhesive layer 2 curve, the electromagnetic-wave absorbing sheet deforms following the shape change, and thus the reflective layer 3 can be formed as a layer that can maintain an electric resistance of about 1 $\Omega$/sq. without the surface electric resistance increasing.

Note that there is no particular limitation on the type of metal forming the reflective layer 3, and in addition to silver described above, it is possible to use a highly-corrosion-resistant metal whose electric resistance is as low as possible, such as aluminum, copper, or chromium.

In a first configuration of the electromagnetic-wave absorbing sheet according to the present embodiment shown in FIG. 1, it is possible to reliably avoid a situation in which electromagnetic waves penetrate through the electromagnetic-wave absorbing sheet due to the reflective layer 3 being provided on the back surface side of the electromagnetic-wave absorbing layer 1 and the adhesive layer 2. For this reason, the first configuration can be preferably used as an electromagnetic-wave absorbing sheet that prevents leakage of electromagnetic waves that are discharged to the outside from an electrical circuit component or the like driven at a high frequency, in particular.

[Impedance Matching]

Here, the effect of the dielectric layer provided on the back surface side of the electromagnetic-wave absorbing layer in the electromagnetic-wave absorbing sheet according to the present embodiment will be described.

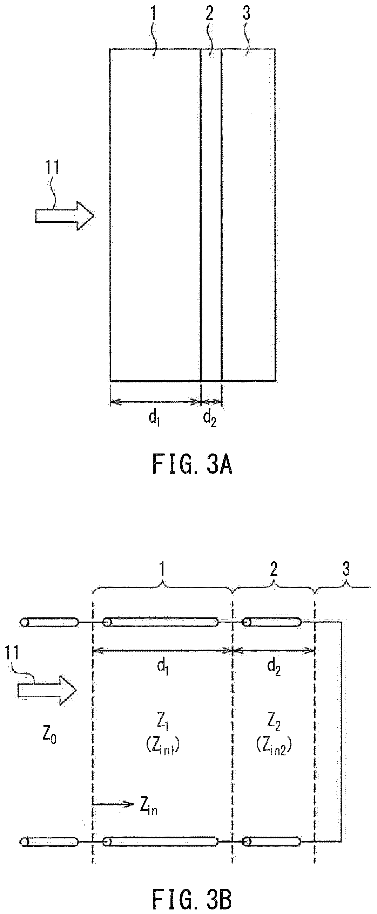

FIG. 3 is a diagram illustrating the influence that the electromagnetic-wave absorbing sheet has on the input impedance due to the dielectric layer being arranged between the electromagnetic-wave absorbing layer and the reflective layer in a first exemplary configuration of the electromagnetic-wave absorbing sheet according to the present embodiment illustrated in FIG. 1.

As shown in FIG. 3(a), the electromagnetic-wave absorbing sheet according to the present embodiment is constituted by stacking the electromagnetic-wave absorbing layer 1, the adhesive layer 2 serving as the dielectric layer, and the reflective layer 3, starting from the incident side of electromagnetic waves 11 that are to be absorbed. Note that as shown in FIG. 3(a), the thickness of the electromagnetic-wave absorbing layer 1 is d1, and the thickness of the adhesive layer 2 is d2. The reflective layer 3 reflects the electromagnetic waves at the boundary surface with the adhesive layer 2, and therefore the thickness of the reflective layer 3 does not need to be considered when examining the overall input impedance of the electromagnetic-wave absorbing sheet.

An equivalent circuit of the electromagnetic-wave absorbing sheet shown in FIG. 3(a) can be expressed as in FIG. 3(b), and with the electromagnetic-wave absorbing sheet, the impedance $Z_1$ of the electromagnetic-wave absorbing layer 1 and the impedance $Z_2$ of the adhesive layer 2 are connected in series. Note that the impedance in the air before the electromagnetic waves 11 are incident on the electromagnetic-wave absorbing sheet is $Z_0$.

The input impedance ($Z_{in2}$) of the adhesive layer 2, which takes into account the reflective layer 3, is calculated and the input impedance ($Z_{in1}$) from the front surface of the electromagnetic-wave absorbing layer 1 is calculated using the calculated input impedance ($Z_{in2}$) as the load impedance. $Z_{in1}$ is the input impedance $Z_{in}$ of the electromagnetic-wave absorbing sheet.

Note that as will be described later, the electromagnetic-wave absorbing layer and the dielectric layer can both have a configuration in which multiple layers are stacked. For example, if the electromagnetic-wave absorbing sheet has a configuration in which N layers whose impedances are $Z_1$, $Z_2$, $Z_3$, ..., and $Z_N$ starting from the incident side of the electromagnetic waves 11 are arranged in front of the reflective layer, an overall input impedance $Z_{in}$ can be obtained by repeating the above-described procedure.

In this manner, the input impedance $Z_{in}$ of the electromagnetic-wave absorbing sheet according to the present embodiment is indicated as the following equation (1).

[Equation 1]

$$z_{inN} = \sqrt{\frac{\mu_{rN}}{\varepsilon_{rN}}} \tan\left(i \frac{2\pi d_N}{\lambda} \sqrt{\varepsilon_{rN}\mu_{rN}}\right) \qquad (1)$$

Note that in equation (1) above, $\mu_{rN}$ is the complex permeability of the N-th layer, $\varepsilon_{rN}$ is the complex permittivity of the N-th layer, $\lambda$ is the wavelength of the incident electromagnetic waves, and $d_N$ is the thickness of the N-th layer. Here, $Z_0$ is the impedance value in a vacuum state, which is about 377 $\Omega$, and is a value that is approximately equal to the impedance in the air. For this reason, by making the value of $Z_{in}$ equal to $Z_0$, the impedance in the air and the impedance of the electromagnetic-wave absorbing layer 1 can be matched, and thereby the electromagnetic waves that have been transmitted through the air can be incident on the electromagnetic-wave absorbing layer 1 as-is without being reflected or dispersed by the front surface of the electromagnetic-wave absorbing layer 1 of the electromagnetic-wave absorbing sheet. In this manner, by performing impedance matching on the electromagnetic-wave absorbing layer 1 to reduce reflection of the electromagnetic waves and allow them to be incident as-is on the front surface of the electromagnetic-wave absorbing layer 1, it is possible to cause the electromagnetic-wave absorbing property of the electromagnetic-wave absorbing layer 1 itself to be exhibited to the maximum extent.

In equation (1) above, it can be understood that in order to make the value of $Z_{in}$ equal to $Z_0$, if the value of the wavelength $\lambda$ of the electromagnetic waves and the materials of the electromagnetic-wave absorbing layer and the dielectric layer are determined, the values of the thickness $d_1$ of the electromagnetic-wave absorbing layer 1 and the

thickness $d_2$ of the adhesive layer 2 need only be set to predetermined values.

Although the electromagnetic-wave absorbing layer 1 is constituted by including magnetic iron oxide powder 1a, which is a particulate electromagnetic-wave absorbing material, and the rubber binder 1b, the electromagnetic-wave absorbing layer 1 needs to have a predetermined flexibility and include the magnetic iron oxide powder 1a at a volume content that is needed in order to exhibit at least a predetermined electromagnetic-wave absorbing property. Therefore, the impedance $Z_1$ of the electromagnetic-wave absorbing layer 1 cannot necessarily be matched with a desired value in some cases. However, in the case of using the electromagnetic-wave absorbing sheet according to the present embodiment, the adhesive layer 2, which is a dielectric layer, is formed on the back surface of the electromagnetic-wave absorbing layer 1, and therefore even if there is a limitation on the impedance of the electromagnetic-wave absorbing layer 1, the input impedance $Z_{in}$ of the electromagnetic-wave absorbing sheet can be adjusted and matched with the impedance $Z_0 = 377\ \Omega$ in the air by adjusting the thickness of the adhesive layer 2 as described above.

As a result, it is possible to realize an electromagnetic-wave absorbing sheet having a desired flexibility and electromagnetic-wave absorbing property. Compared to the case of matching the input impedance $Z_{in}$ of the electromagnetic-wave absorbing sheet with the impedance $Z_0$ in the air using only the material and the thickness of the electromagnetic-wave absorbing layer 1, by including the adhesive layer 2, which has a predetermined impedance $Z_2$ at a predetermined thickness, it is possible to reduce the thickness of the electromagnetic-wave absorbing layer 1, it is possible to realize a reduction of the overall weight of the electromagnetic-wave absorbing sheet by reducing the number of electromagnetic-wave absorbing layers 1, which are heavy due to including the magnetic iron oxide powder 1a, and it is possible to realize a lower cost of the electromagnetic-wave absorbing sheet by reducing the usage amount of the magnetic iron oxide powder 1a, which is expensive.

[Second Configuration]

Next, a second configuration of the electromagnetic-wave absorbing sheet according to the present embodiment will be described.

FIG. 4 is a cross-sectional view for illustrating a second configuration of the electromagnetic-wave absorbing sheet according to the present embodiment.

As shown in FIG. 4, the second configuration is constituted by the electromagnetic-wave absorbing layer 1 and the adhesive layer 2 and does not include the reflective layer 3 on the back surface of the adhesive layer 2 as in the first configuration.

In the electromagnetic-wave absorbing sheet according to the present embodiment, the electromagnetic-wave absorbing layer 1 includes magnetic iron oxide powder 1a, which serves as an electromagnetic-wave absorbing material, and the electromagnetic waves, which are electromagnetic waves, are converted into heat energy and absorbed through magnetic loss as a result of the magnetic iron oxide powder 1a undergoing magnetic resonance. For this reason, as shown in FIG. 4, even in a state in which no reflective layer is provided on the back surface side of the stacked configuration of the electromagnetic-wave absorbing layer 1 and the adhesive layer 2, the electromagnetic-wave absorbing sheet according to the present embodiment can be used as a so-called transmissive electromagnetic-wave absorbing sheet that absorbs the electromagnetic waves that pass through the electromagnetic-wave absorbing layer 1.

Note that in the second configuration of the electromagnetic-wave absorbing sheet according to the present embodiment, the same material as that constituting the electromagnetic-wave absorbing sheet of the first configuration shown in FIG. 1 can be used in the electromagnetic-wave absorbing layer 1 and the adhesive layer 2, and therefore in FIG. 4 as well, the electromagnetic-wave absorbing layer 1 and the adhesive layer 2 are denoted by the same reference numerals as in FIG. 1 and detailed description thereof is omitted.

In the second configuration of the electromagnetic-wave absorbing sheet shown in FIG. 4 as well, the adhesive layer 2 can be used as a dielectric layer. With the electromagnetic-wave absorbing sheet of the second configuration, the reflective layer is not arranged on the back surface of the adhesive layer 2, but the adhesive layer 2 is formed on the rear surface side of the electromagnetic-wave absorbing sheet, which is advantageous when adhering the electromagnetic-wave absorbing sheet to a predetermined location. Also, in the second configuration of the electromagnetic-wave absorbing sheet shown in FIG. 4 as well, it is important that the electromagnetic-wave absorbing layer 1 and the adhesive layer 2 are arranged in sufficiently close contact, and therefore it is thought that it is preferable to use the dielectric layer as the adhesive layer 2 having the adhesion function.

Note that even with an electromagnetic-wave absorbing sheet that does not include the reflective layer, which is the second configuration, if the real part $\varepsilon'$ of the complex relative permittivity is 2 or more and 6 or less and the thickness of the dielectric layer is not 10 $\mu$m or more and 100 $\mu$m or less, it is not possible to obtain the effect of increasing the electromagnetic wave attenuation amount. The reason for this is that divergence (a difference) occurs in the impedance between the electromagnetic-wave absorbing layer and the dielectric layer, and reflection of the electromagnetic waves occurs at the boundary surface between the electromagnetic-wave absorbing layer and the dielectric layer, whereby the electromagnetic-wave absorbing effect decreases.

Examples

Hereinafter, conditions that are preferable for the dielectric layer will be examined using the electromagnetic-wave absorbing sheets of examples according to the present embodiment.

First, a transmissive electromagnetic-wave absorbing sheet that does not include the reflective layer and is shown in FIG. 4 was produced.

The electromagnetic-wave absorbing sheets of the examples included epsilon iron oxide with an average particle diameter of 30 nm as the electromagnetic-wave absorbing material in the electromagnetic-wave absorbing layer, and had a square shape with a 120-mm side, the sheets being prepared using "KE-510-U" (product name) manufactured by Shin-Etsu Chemical Co., Ltd. as the rubber binder, and "KEM-3103" (product name) manufactured by Shin-Etsu Chemical Co., Ltd. as the dispersant.

Note that the thickness of the electromagnetic-wave absorbing layer was kept at 0.9 mm in the reflective electromagnetic-wave absorbing sheet, and 2.5 mm in the transmissive electromagnetic-wave absorbing sheet.

The dielectric layer was formed as an adhesive layer having adhesiveness, the adhesive layer being obtained by dispersing titanium dioxide with an average particle diameter of 0.21 $\mu$m ("CR-60" (product name) manufactured by Ishihara Sangyo Kaisha, Ltd.) as a high-permittivity ceramic, in a butyl rubber-based adhesive at a predetermined percentage using a pressurizing kneader, and the adhesive layer was adhered to the back surface of the electromagnetic-wave absorbing layer.

The amount of titanium dioxide added was changed in order to change the permittivity of the dielectric layer, and in the following examples and comparative examples, with respect to 100 parts of the butyl rubber-based adhesive, the content of titanium dioxide was 3 parts for a permittivity of 3.2, 10 parts for a permittivity of 5.8, 15 parts for a permittivity of 7.7, and the permittivity in the case of using only the butyl rubber-based adhesive was 2.1. Also, a dielectric layer with a permittivity of 1.9 was produced by mixing 20 parts of talc with respect to 100 parts of butyl rubber-based adhesive.

A reflective electromagnetic-wave absorbing sheet was formed by laminating an aluminum foil with a thickness of 7 $\mu$m on the back surface of the electromagnetic-wave absorbing layer including the electromagnetic-wave absorbing layer and the dielectric layer, which were produced as described above, at the time of measurement.

Measurement of the electromagnetic-wave absorption amount was performed using a free space method. Specifically, measurement was performed using a millimeter-wave network analyzer N5250C (product name) manufactured by Agilent Technologies, Inc., input waves (millimeter waves) of a predetermined frequency were emitted from a transmitting/receiving antenna to the electromagnetic-wave absorbing sheet via a dielectric lens using one port, the waves reflected from the electromagnetic-wave absorbing sheet were measured, the intensity of the input waves and the intensity of the reflected waves were compared, and thus the reflection attenuation rate RL (return loss), which is the degree of attenuation, was obtained in dB.

Note that the RL was calculated with the following equation (2).

[Equation 2]

$$RL = 20 log_{10} \left| \frac{z_{in} - z_0}{z_{in} + z_0} \right| \qquad (2)$$

Also, with the transmissive electromagnetic-wave absorbing sheet, a reception antenna was arranged on the back surface of the electromagnetic-wave absorbing sheet, and the electromagnetic waves that were emitted from the transmission antenna and passed through the electromagnetic-wave absorbing sheet were measured.

Note that in the measurement of the permittivity of the dielectric layer as well, the electromagnetic waves were emitted to the dielectric layer using a free space method, similarly to the above description, and the permittivity was calculated based on the reflection and transmission property (S parameter) of the electromagnetic waves.

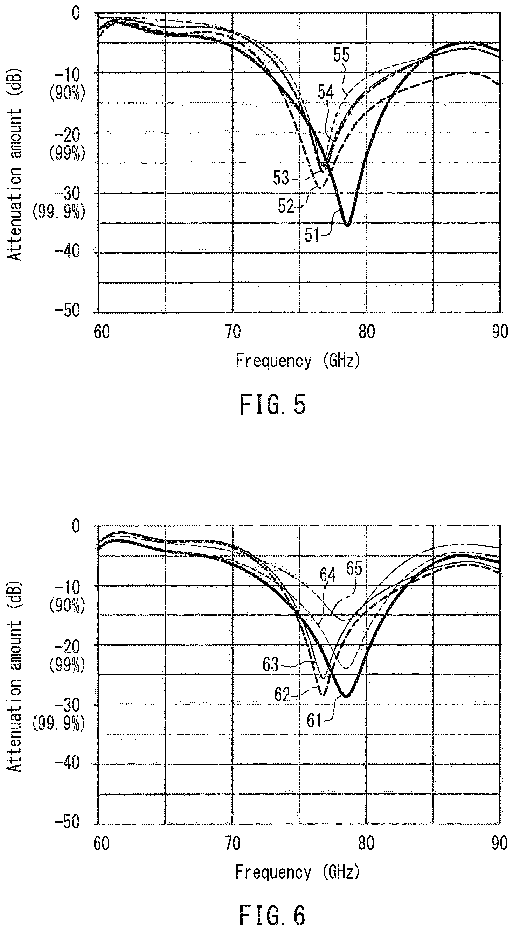

Table 1 and FIG. 5 show measurement results obtained by measuring changes in the electromagnetic-wave absorbing effect caused by differences in the permittivities of the dielectric layers in the reflective electromagnetic-wave absorbing sheets.

[Table 1]

| | Dielectric layer | | Attenuation amount (dB) | Reference numeral |
|---|---|---|---|---|
| | Permittivity | Thickness ($\mu$m) | | |
| Ex. 1 | 5.8 | 20 | -35.4 | 51 |
| Ex. 2 | 3.2 | 20 | -29.1 | 52 |
| Ex. 3 | 2.1 | 20 | -26.5 | 53 |

(continued)

| | Dielectric layer | | Attenuation amount (dB) | Reference numeral |
| --- | --- | --- | --- | --- |
| | Permittivity | Thickness ($\mu$m) | | |
| Comp. Ex. 1 | - | - | -25.4 | 54 |
| Comp. Ex. 2 | 1.9 | 2.0 | -25.4 | 55 |
| * Ex.: Example, Comp. Ex.: Comparative Example | | | | |

As shown in Table 1, if the amount of titanium dioxide added is adjusted as described above to change the permittivity of the dielectric layer with the thickness of the dielectric layer kept constant at 20 $\mu$m, the electromagnetic-wave absorbing property in the electromagnetic-wave absorbing sheet of Example 1 (reference numeral 51 in FIG. 5), which has a permittivity of 5.8, which is the highest, reaches -35.4 dB, which is the highest, the electromagnetic-wave absorbing property of the electromagnetic-wave absorbing sheet of Example 2 (reference numeral 52), which has a permittivity of 3.2, reaches -29.1 dB, and the electromagnetic-wave absorbing property of the electromagnetic-wave absorbing sheet of Example 3 (reference numeral 53), which has a permittivity of 2.1, reaches -26.5 dB. Thus, as the permittivity decreases, the electromagnetic-wave absorbing property also decreases. However, the attenuation amount, which is the electromagnetic-wave absorbing property of the electromagnetic-wave absorbing sheet of Example 3, significantly surpasses -25 dB and reaches a value close to 99.9% when converted into the attenuation rate, and therefore it can be said that a sufficient attenuation property is exhibited.

On the other hand, in the case of using an electromagnetic-wave absorbing sheet that has only the electromagnetic-wave absorbing layer and does not include the dielectric layer, and which was produced as Comparative Example 1 (reference numeral 54), the attenuation amount reaches -25.4 dB and stops at a level that cannot be said to be a sufficient value when compared with the cases of the Examples including the dielectric layers.

Also, it was confirmed that even if the dielectric layer is formed, in the case of using the electromagnetic-wave absorbing sheet of Comparative Example 2 (reference numeral 55) with a permittivity of 1.9, the attenuation amount reached -25.4 dB and a sufficient attenuation effect could not be exhibited.

That is, with the electromagnetic-wave absorbing sheet of Comparative Example 1, the impedance $Z_{in1}$ of the electromagnetic-wave absorbing layer cannot be sufficiently matched with the impedance $Z_0$ in the air, whereas in the electromagnetic-wave absorbing sheets of Example 1, Example 2, and Example 3, as the input impedance $Z_{in}$ of the electromagnetic-wave absorbing sheet, the impedance $Z_{in2}$ of the dielectric layer is added to the impedance $Z_{in1}$ of the electromagnetic-wave absorbing layer, and therefore it is understood that impedance matching is performed more favorably with the impedance $Z_0$ in the air. Also, with the electromagnetic-wave absorbing sheet of Comparative Example 2, it can be understood that the input impedance $Z_{in}$ of the electromagnetic-wave absorbing sheet combined with the impedance $Z_{in2}$ of the dielectric layer was not matched with the impedance $Z_0$ in the air.

Note that in FIG. 5, with the electromagnetic-wave absorbing property of Example 1, which is indicated by reference numeral 51, the peak of absorption is about 78 GHz, whereas the peak frequency of absorption in the electromagnetic-wave absorbing sheets of Example 2, Example 3, Comparative Example 1, and Comparative Example 2 is about 76 GHz. However, this is not a significant problem from the viewpoint of verifying the effect that the inclusion of the dielectric layer, which is the measurement target in this instance, has on the electromagnetic-wave absorbing property.

Next, Table 2 and FIG. 6 show second measurement results obtained by measuring changes in the electromagnetic-wave absorbing effect caused by differences in the permittivities of the dielectric layers 2 in the reflective electromagnetic-wave absorbing sheets.

[Table 2]

| | Dielectric layer | | Attenuation amount (dB) | Reference numeral |
| --- | --- | --- | --- | --- |
| | Permittivity | Thickness ($\mu$m) | | |
| Ex. 4 | 5.8 | 50 | -28.7 | 61 |
| Ex. 5 | 2.1 | 50 | -28.5 | 62 |
| Comp. Ex. 1 | - | - | -25.4 | 63 |
| Comp. Ex. 3 | 7.7 | 50 | -23.8 | 64 |
| Comp. Ex. 4 | 7.7 | 100 | -15.9 | 65 |

As a second measurement, the changes in the electromagnetic-wave absorbing properties caused by differences in the permittivities of the dielectric layers in the case of including a dielectric layer having a thickness of 50 μm or 100 μm, which is thicker than that shown in Table 1 and FIG. 5, are indicated as the attenuation amounts. As shown in Table 2, it is understood that even when the thickness of the dielectric layer is 50 μm, the electromagnetic-wave absorbing sheet of Example 4 (reference numeral 61 in FIG. 6), which is provided with a dielectric layer with a permittivity of 5.8, has an attenuation amount of -28.7 dB, and the electromagnetic-wave absorbing sheet of Example 5 (reference numeral 62), which is provided with a dielectric layer with a permittivity of 2.1, has an attenuation amount of -28.5 dB, both of which are greater electromagnetic-wave absorbing properties than the attenuation amount -25.4 dB of Comparative Example 1 (reference numeral 63), which is not provided with the dielectric layer.

Note that even if the dielectric layer is formed, if the dielectric layer has a permittivity of 7.7, the attenuation amount in the case of Comparative Example 3 (reference numeral 64) in which the thickness of the dielectric layer is 50 μm is -23.8 dB, the attenuation amount in the case of Comparative Example 4 (reference numeral 65) in which the thickness is 100 μm is -15.9 dB, and thus both of the electromagnetic-wave absorbing properties are lower than that of the electromagnetic-wave absorbing sheet of Comparative Example 1, which does not include the dielectric layer.

This is thought to be because the overall input impedance $Z_{in}$ of the electromagnetic-wave absorbing sheet obtained by combining the permittivity of the dielectric layers of Comparative Example 3 and Comparative Example 4 with the permittivity of the electromagnetic-wave absorbing layer more significantly shifts from 377 Ω, which is the impedance $Z_0$ in the air.

Note that in FIG. 6 as well, the peak of the absorption frequencies of Example 4, Comparative Example 3, and Comparative Example 4 is about 78 GHz, whereas the peak of the absorption frequency of Example 5 is not 76 GHz, which is the same as that of Comparative Example 1. However, it can be clearly understood that the magnitude of the attenuation amount at the peak of absorption is to be considered important in this instance of measurement, and the peaks of the graphs of Example 4 and Example 5 are located below the peaks of Comparative Example 1, Comparative Example 3, and Comparative Example 4, and thus a greater attenuation effect has been exhibited.

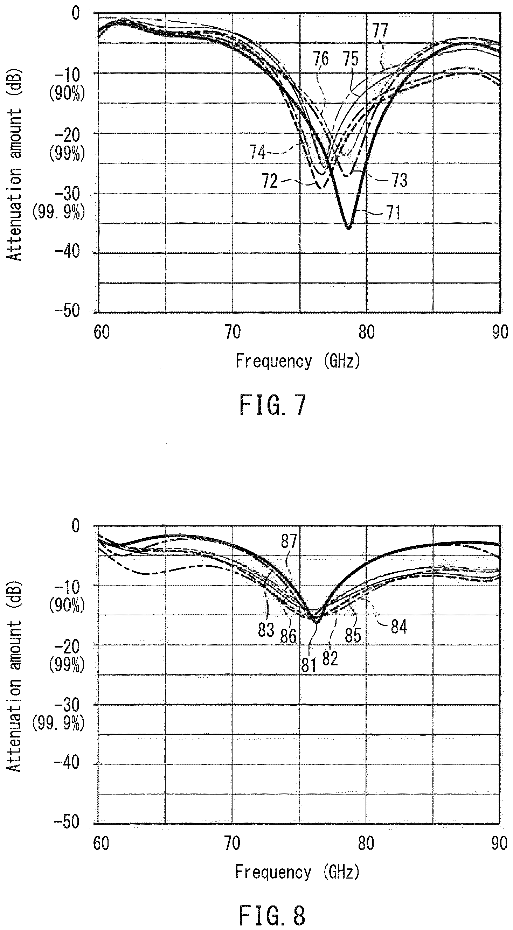

Next, Table 3 and FIG. 7 show measurement results obtained by measuring changes in the electromagnetic-wave absorbing effect caused by differences in the thicknesses of the dielectric layers 2 in the reflective electromagnetic-wave absorbing sheets.

[Table 3]

| | Dielectric layer | | Attenuation amount (dB) | Reference numeral |
|---|---|---|---|---|
| | Permittivity | Thickness (μm) | | |
| Ex. 6 | 3.2 | 70 | -35.8 | 71 |
| Ex. 2 | 3.2 | 20 | -29.1 | 72 |
| Ex. 7 | 3.2 | 100 | -27.3 | 73 |
| Ex. 8 | 3.2 | 10 | -26.9 | 74 |
| Comp. Ex. 1 | - | - | -25.4 | 75 |
| Comp. Ex. 5 | 3.2 | 120 | -23.7 | 76 |
| Comp. Ex. 6 | 3.2 | 8 | -25.4 | 77 |
| Ex. 9 | 3.2 | 70 | -31.7 | 91 |
| Ex. 10 | 3.2 | 10 | -22.5 | 92 |
| Comp. Ex. 7 | - | - | -21.2 | 93 |
| Comp. Ex. 8 | 3.2 | 8 | -21.4 | 94 |

Here, the electromagnetic-wave absorbing properties of the electromagnetic-wave absorbing sheets resulting from changing the thickness of the dielectric layer in the case of keeping the permittivity of the dielectric layer constant at 3.2 as shown in Table 3 are compared as attenuation amounts.

As shown in Table 3, the attenuation amount of Example 6 (reference numeral 71 in FIG. 7), in which the thickness of the dielectric layer is set to 70 μm in the case of keeping the permittivity constant at 3.2, is -35.8 dB, which is the largest. In contrast to this, the attenuation amount of Example 2 (reference numeral 72) in the case where the dielectric layer is thinner at a thickness of 20 μm is -29.1 dB, and the attenuation amount of Example 7 (reference numeral 73) in which the dielectric layer is thicker at 100 μm is -27.3 dB, both of which are lower. Accordingly, in the case of using a dielectric layer with a permittivity of 3.2 in combination with the electromagnetic-wave absorbing layer used in this instance of measurement, it can be understood that it is preferable to set the thickness of the dielectric layer to around 70 μm.

Note that even in the case of Example 8 (reference numeral 74) in which the dielectric layer is thinner at a thickness of 10 $\mu$m, the attenuation amount is -26.9 dB, and thus an attenuation effect greater than the attenuation amount -25.4 dB of the electromagnetic-wave absorbing sheet of Comparative Example 1 (reference numeral 75) that does not include the dielectric layer is exhibited.

On the other hand, if the thickness of the dielectric layer is increased, in the case of Comparative Example 5 (reference numeral 76) in which the thickness is 120 $\mu$m, which exceeds 100 $\mu$m, the attenuation amount significantly decreases to -2.37 dB. Accordingly, it is indicated that if the thickness of the dielectric layer exceeds 100 $\mu$m, it is difficult to realize an electromagnetic-wave absorbing sheet including favorable electromagnetic-wave absorbing properties.

Also, as an example in which the thickness of the dielectric layer is conversely too small, in the case of Comparative Example 6 (reference numeral 77) in which the thickness is 8 $\mu$m, which is smaller than 10 $\mu$m, the attenuation amount stops at -25.4, which is a level similar to that in the case of Comparative Example 1 in which no dielectric layer is formed. Accordingly, it can be understood that if the thickness of the dielectric layer does not reach 10 $\mu$m, it is difficult to realize the electromagnetic-wave absorbing sheet including favorable electromagnetic-wave absorbing properties.

Furthermore, regarding the case of using strontium ferrite as the electromagnetic-wave absorbing material, the electromagnetic-wave absorbing properties in the case of similarly providing a dielectric layer with a permittivity of 3.2 and a different thickness was measured as the electromagnetic wave attenuation amount.

The measurement sample was produced by changing the electromagnetic-wave absorbing material from epsilon iron oxide powder to strontium ferrite powder in the samples created in the above-described examples and comparative examples. The strontium ferrite powder used as the electromagnetic-wave absorbing material had the composition (molar ratio) $SrFe_{10.56}Al_{1.44}O_{19}$, and an average particle diameter of 12.7 $\mu$m.

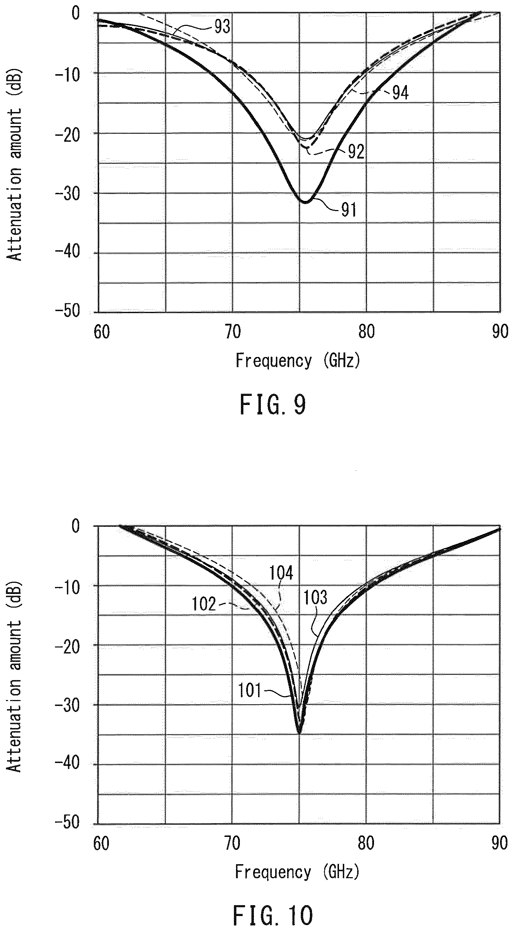

The measurement results are shown in Table 3 and FIG. 9. In Table 3, the absorption properties of the electromagnetic-wave absorbing sheets using strontium ferrite are shown in the portion below the double line in the middle.

Comparative Example 7, which is indicated as reference numeral 93 in FIG. 9, is a case in which no dielectric layer is provided. In contrast to this, Example 9 (reference numeral 91 of FIG. 9), which is provided with a dielectric layer with a thickness of 70 $\mu$m, and Example 10 (reference numeral 92 of FIG. 9), which is provided with a dielectric layer with a thickness of 10 $\mu$m, both have improved electromagnetic-wave absorbing properties.

On the other hand, in Comparative Example 8 (reference numeral 94 of FIG. 9) in which the permittivity is the same at 3.2 but the thickness is 8 $\mu$m, which does not satisfy the preferable condition of being 10 $\mu$m or more and 100 $\mu$m or less, only an electromagnetic-wave absorbing property that is approximately the same as that of Comparative Example 7, which is not provided with a dielectric layer, was obtained, and the effect of providing the dielectric layer was not confirmed.

Thus, it was confirmed that even if the type of the electromagnetic-wave absorbing material is changed, due to satisfying the conditions that the real part of the complex relative permittivity of the dielectric layer is 2 or more and 6 or less, and that the thickness of the dielectric layer is 10 $\mu$m or more and 100 $\mu$m or less, an electromagnetic-wave absorbing sheet having a preferable electromagnetic-wave absorbing property is obtained.

Next, the results of measuring the electromagnetic-wave absorbing properties of transmissive electromagnetic-wave absorbing sheets will be described.

Table 4 and FIG. 8 show second measurement results obtained by measuring changes in the electromagnetic-wave absorbing effect caused by differences in the permittivities of the dielectric layers in the transmissive electromagnetic-wave absorbing sheets in the case of using epsilon iron oxide powder as the electromagnetic-wave absorbing material.

[Table 4]

| | | Dielectric layer | | Attenuation amount (dB) | Reference numeral |
|---|---|---|---|---|---|
| | | Permittivity | Thickness ($\mu$m) | | |
| | Ex. 11 | 5.8 | 100 | -16.2 | 81 |
| | Ex. 12 | 3.2 | 100 | -15.5 | 82 |
| | Ex. 13 | 3.2 | 70 | -15.2 | 83 |
| | Ex. 14 | 2.1 | 100 | -15.0 | 84 |
| | Comp. Ex. 11 | - | - | -14.1 | 85 |
| | Comp. Ex. 12 | 1.9 | 20 | -14.1 | 86 |
| | Comp. Ex. 13 | 2.1 | 9 | -14.1 | 87 |
| | Ex. 15 | 5.8 | 100 | -34.7 | 101 |

(continued)

| | Dielectric layer | | Attenuation amount (dB) | Reference numeral |
|---|---|---|---|---|
| | Permittivity | Thickness ($\mu$m) | | |
| Ex. 16 | 2.1 | 100 | -33.6 | 102 |
| Comp. Ex. 14 | - | - | -30.5 | 103 |
| Comp. Ex. 15 | 2.1 | 9 | -30.5 | 104 |

In the case of the transmissive electromagnetic-wave absorbing sheet, the electromagnetic-wave absorbing property decreases overall compared to the reflective electromagnetic-wave absorbing sheet. As shown in Table 4, the electromagnetic-wave absorbing sheet of Example 11 (reference numeral 81 in FIG. 8), which is provided with a dielectric layer with a permittivity of 5.8 and a thickness of 100 $\mu$m, has an attenuation amount of -16.2 dB, the electromagnetic-wave absorbing sheet of Example 12 (reference numeral 82), which is provided with a dielectric layer with a permittivity of 3.2 and a thickness of 100 $\mu$m, has an attenuation amount of -15.5 dB, the electromagnetic-wave absorbing sheet of Example 13 (reference numeral 83), which is provided with a dielectric layer with a permittivity of 3.2 and a thickness of 100 $\mu$m, has an attenuation amount of -15.2 dB, and the electromagnetic-wave absorbing sheet of Example 14 (reference numeral 84), which is provided with a dielectric layer with a permittivity of 2.1 and a thickness of 100 $\mu$m, has an attenuation amount of -15.0 dB.

In contrast to this, with the electromagnetic-wave absorbing sheet of Comparative Example 11 (reference numeral 85), in which no dielectric layer is formed, the attenuation rate is -14.1 dB, which is low. Also, in the case of Comparative Example 12 (reference numeral 86), in which the thickness of the dielectric layer is 20 $\mu$m but the permittivity is 1.9, which is low, and furthermore, in the case of Comparative Example 13 (reference numeral 89), in which the thickness of the dielectric layer is 9 $\mu$m, which is thin, even though the permittivity is 2.1, which is the same as in Example 14, in both cases, the attenuation rate stops at -14.1 dB, which is the same as in Comparative Example 11, in which no dielectric layer is formed.

Thus, even in the case of the transmissive electromagnetic-wave absorbing sheet, it is standard to realize, as the attenuation amount, an attenuation amount of -15 dB, which corresponds to an attenuation rate of about 90% or more. Therefore, it is understood that an electromagnetic-wave absorbing sheet with a higher electromagnetic-wave absorbing property can be realized by including a dielectric layer with a permittivity of 2 or more and 6 or less, and a thickness of 70 $\mu$m to 100 $\mu$m.

In the case of the transmissive electromagnetic-wave absorbing sheet as well, similarly to the case of the above-described reflective electromagnetic-wave absorbing sheet, an electromagnetic-wave absorbing sheet obtained by replacing the electromagnetic-wave absorbing material with strontium ferrite was produced, and the electromagnetic-wave absorbing property thereof was measured.

The strontium ferrite powder used as the measurement sample had the composition (molar ratio) $SrFe_{10.56}Al_{1.44}O_{19}$ and had an average particle diameter of 12.7 $\mu$m, similarly to the sample in the case of the above-described reflective electromagnetic-wave absorbing sheet.

The measurement results for the transmissive electromagnetic-wave absorbing sheets are shown in Table 4 and FIG. 10. In Table 4, similarly to Table 3, the absorption properties of the electromagnetic-wave absorbing sheets in which strontium ferrite is used are shown in the portion below the double line in the middle.

Comparative Example 14, which is indicated as reference numeral 103 in FIG. 10, is a case in which no dielectric layer is provided. In contrast to this, Example 15 (reference numeral 101 in FIG. 10), which is provided with a dielectric layer with a thickness of 100 $\mu$m and a permittivity of 5.8, and Example 16 (reference numeral 102 in FIG. 10), which is provided with a dielectric layer with a thickness of 100 $\mu$m and a permittivity of 2.1, both have improved electromagnetic-wave absorbing properties.

On the other hand, in Comparative Example 15 (reference numeral 104 in FIG. 10), in which the permittivity is 2.1 similarly to Comparative Example 16 described above, but the thickness of the dielectric layer is 9 $\mu$m, which does not satisfy the condition of being 10 $\mu$m or more and 100 $\mu$m or less, the wavelength of the absorbed electromagnetic waves is slightly shifted, but with regard to the electromagnetic wave attenuation amount, only an electromagnetic-wave absorbing property that is approximately the same as that of Comparative Example 14, in which no dielectric layer is provided, was obtained, and thus the effect of providing the dielectric layer was not confirmed.

Thus, in the case of the transmissive electromagnetic-wave absorbing sheet as well, it was confirmed that due to the type of the electromagnetic-wave absorbing material being changed, the conditions for a preferable dielectric layer, that is, the conditions that the real part of the complex relative permittivity is 2 or more and 6 or less and the thickness is 10 $\mu$m or more and 100 $\mu$m or less, are satisfied, whereby an electromagnetic-wave absorbing sheet having a preferable electromagnetic-wave absorbing property is obtained. As described above, with the electromagnetic-wave absorbing sheet according to the present embodiment, regardless of being reflective or transmissive, by including the non-magnetic dielectric layer on the back surface of the electromagnetic-wave absorbing layer, the input impedance $Z_{in}$ of the electromagnetic-wave absorbing sheet can be adjusted without influencing the electromagnetic-wave absorbing property resulting from the electromagnetic-wave absorbing material of the electromagnetic-wave absorbing layer, and the electromagnetic-wave absorbing property can be improved through matching with the impedance $Z_0$ in the air.

Note that strictly speaking, the conditions on the permittivity and the thickness of the dielectric layer are determined through balance with the impedance of the electromagnetic-wave absorbing layer determined according to the material and thickness of the electromagnetic-wave absorbing layer. However, in the electromagnetic-wave absorbing sheet disclosed in the present application, there are limitations based on specific conditions resulting from, for example, the fact that the rubber binder is included as the electromagnetic-wave absorbing layer and the dielectric layer has flexibility. For this reason, as shown in Tables 1 to 4, which show the results of examining the above-described examples, it is necessary that the permittivity of the dielectric layer (in this case, the real part of the complex relative permittivity is used since the electric characteristics are considered) is 2 or more and 6 or less, and the thickness of the dielectric layer is 10 $\mu$m or more and 100 $\mu$m or less.

Note that in the above-described embodiment, a case was described in which an adhesive layer having adhesiveness was used as the dielectric layer. However, in the electromagnetic-wave absorbing sheet according to the present embodiment, the dielectric layer does not need to be an adhesive layer, and it is possible to form only a layer having a predetermined permittivity without using a configuration in which a functional layer including another specialized function is used as the dielectric layer, it is possible to form a dielectric layer as a functional layer including a function of being fire-retardant using a dielectric material including a fire-retardant property, and the like.

Also, for example, if close contact between the electromagnetic-wave absorbing layer and the dielectric layer is reliably obtained, such as a case in which the dielectric layer can be formed through stacking on the electromagnetic-wave absorbing layer, it is possible to form an electromagnetic-wave absorbing sheet configured by bringing the electromagnetic-wave absorbing layer, the dielectric layer, and the reflective layer into close contact with each other by forming an adhesive layer only between the dielectric layer and the reflective layer. In this case, the dielectric layer has a configuration in which two dielectric layers are stacked, one of the two layers not having adhesiveness on the electromagnetic-wave absorbing layer side, and the other having adhesiveness on the reflection layer side, and thus the permittivity of the dielectric layer and the thickness of the dielectric layer are understood as overall numeric values of the dielectric layer in the two-layer structure. It is also possible to use a dielectric layer with a three-layer configuration in which both surfaces of a dielectric layer not having adhesiveness are sandwiched between dielectric layers having adhesiveness, or a dielectric layer with a multi-layer structure of four layers or more.

It is also possible to employ a method of spraying or applying silver nanowires or a conductive polymer onto the back surface side of the dielectric layer as the method of forming a reflective layer onto the back surface side of the dielectric layer not having adhesiveness. It is also possible to employ a method of producing an elastic reflective layer obtained by dispersing silver nanowires or a conductive polymer in a binder including a dielectric material similar to that of the dielectric layer, and thermally press-molding the produced reflective layer to the back surface of the dielectric layer, and furthermore, a method of forming an elastic reflective layer, thereafter stacking the dielectric layer and the electromagnetic-wave absorbing layer to produce the electromagnetic-wave absorbing sheet, and performing vulcanized adhesion on a rubber binder including a dielectric layer and a metal foil, a conductive film, and conductive mesh.

(Other Configurations)

Note that with the electromagnetic-wave absorbing sheet according to the above-described embodiments, description was given illustrating two types, namely a type using epsilon iron oxide as the electromagnetic-wave absorbing material included in the electromagnetic-wave absorbing layer and a type using strontium ferrite as the electromagnetic-wave absorbing material, in both a reflective first configuration and a transmissive second configuration. As described above, by using epsilon iron oxide, it is possible to form an electromagnetic-wave absorbing sheet that absorbs electromagnetic waves of 30 GHz to 300 GHz, which is the millimeter-wave band. Also, by using rhodium or the like as the metal material with which the Fe sites are substituted, it is possible to realize an electromagnetic-wave absorbing sheet that absorbs electromagnetic waves of 1 THz, which is the maximum frequency defined as an electromagnetic wave.

Also, even when strontium ferrite was used as the electromagnetic-wave absorbing material, an electromagnetic-wave absorbing sheet that preferably absorbs electromagnetic waves with a frequency of 75 GHz was obtained.

However, in the electromagnetic-wave absorbing sheet disclosed in the present application, the magnetic iron oxide used as the electromagnetic-wave absorbing material of the electromagnetic-wave absorbing layer is not limited to epsilon iron oxide and strontium ferrite.

Hexagonal ferrite serving as a ferrite-based electromagnetic absorber exhibits an electromagnetic-wave absorbing property in the 76 GHz band. For this reason, an electromagnetic-wave absorbing sheet that absorbs electromagnetic waves in a millimeter-wave band and has flexibility can be realized by forming an electromagnetic-wave absorbing layer using a rubber binder and magnetic iron oxide particles other than epsilon iron oxide and strontium, the magnetic iron oxide particles having an electromagnetic-wave absorbing property at 30 GHz to 300 GHz, which is the millimeter-wave band.

Note that for example, hexagonal ferrite particles have particle diameters that are about several tens of μm larger compared to the epsilon iron oxide particles illustrated in the embodiment, and are crystals whose particle shape is not approximately sphere-shaped, but is plate-shaped or needle-shaped. For this reason, when a magnetic coating is to be formed using a rubber binder, use of a dispersant and conditions of mixing and kneading with a binder are adjusted, and the resulting material is applied as a magnetic coating. In this state, it is preferable to perform adjustment such that the porosity is as small as possible, with the magnetic iron oxide dispersed as evenly as possible in the electromagnetic-wave absorbing layer.

With the electromagnetic-wave absorbing sheet described in the embodiment above, it is possible to realize an electromagnetic-wave absorbing sheet by using a rubber binder that forms the electromagnetic-wave absorbing layer. In particular, by including magnetic iron oxide that magnetically resonates in a high frequency band that is at least a millimeter-wave band as the electromagnetic-wave absorbing material, it is possible to realize an electromagnetic-wave absorbing sheet that absorbs electromagnetic waves with a high frequency and has flexibility.

Note that in the case of using an electromagnetic-wave absorbing sheet in which magnetic iron oxide that absorbs electromagnetic waves through magnetic resonance is used as the electromagnetic-wave absorbing material, it is possible to realize a greater electromagnetic-wave absorbing effect by increasing the volume content of the electromagnetic-wave absorbing material in the electromagnetic-wave absorbing sheet. However, on the other hand, in an electromagnetic-wave absorbing sheet including an electromagnetic-wave absorbing layer constituted by a rubber binder and an electromagnetic-wave absorbing material, the upper limit of the volume content of the electromagnetic-wave absorbing material is necessarily determined from the viewpoint of ensuring the flexibility resulting from using the binder. On the other hand, by setting the lower limit of the volume content of the magnetic iron oxide in the electromagnetic-wave absorbing layer to 30% or more, it is possible to ensure the reflection attenuation amount of the needed level.

Also, in the above description, a method of producing a magnetic compound and performing cross-linking and molding thereon was described as the method for forming the electromagnetic-wave absorbing layer. Other than the above-described method of performing molding and the like on a magnetic compound, it is conceivable to use an extrusion molding method, for example, as the method for producing the electromagnetic-wave absorbing sheet disclosed in the present application.

More specifically, a magnetic iron oxide, a binder, and as needed, a dispersant, and the like are blended in advance using a pressurizing kneader, an extruder, a roll mill, or the like, and these blended materials are supplied into a plastic cylinder from a resin supply port of an extrusion molding machine. Note that a normal extrusion molding machine including a plastic cylinder, a die provided at the leading end of the plastic cylinder, a screw provided so as to be able to rotate in the plastic cylinder, and a drive mechanism for driving the screw can be used as the extrusion molding machine. A molten material plasticized using a band heater of the extrusion molding machine is sent forward due to the rotation of the screw, and is extruded from the leading end in the form of a sheet, whereby an electromagnetic-wave absorbing layer with a predetermined thickness can be obtained.

Also, in the above-described embodiment, an electromagnetic-wave absorbing sheet in which an electromagnetic-wave absorbing layer is formed in one layer was described, but it is possible to use an electromagnetic-wave absorbing sheet in which multiple layers are stacked as the electromagnetic-wave absorbing layer. In the case of using a transmissive electromagnetic-wave absorbing sheet, which was indicated as a second configuration of the electromagnetic-wave absorbing sheet according to the present embodiment, including an electromagnetic-wave absorbing layer with a thickness of a certain degree or more results in improving the electromagnetic-wave absorbing property. Also, even in the case of using the reflective electromagnetic-wave absorbing sheet indicated as the first configuration, the input impedance is easier to match with the impedance value in the air due to the thickness of the electromagnetic-wave absorbing layer being adjusted. For this reason, if an electromagnetic-wave absorbing layer with a predetermined thickness cannot be formed in one layer due to the properties of the electromagnetic-wave absorbing material or the binder forming the electromagnetic-wave absorbing layer, it is effective to form the electromagnetic-wave absorbing layer as a stacked body.

In addition, injection molding, or a calender (roll) molding method can be used according to the viscosity of the magnetic compound.

It is also possible to form the electromagnetic-wave absorbing layer by applying a magnetic coating material.

The magnetic coating material can be obtained by obtaining a kneaded product of an epsilon iron oxide powder, a phosphate compound, which is a dispersant, and a resin binder, diluting the kneaded product with a solvent, and furthermore dispersing the product, and thereafter filtering the resulting mixture with a filter. As an example, the kneaded product is obtained through mixing and kneading with a pressurizing batch kneader. Also, the dispersion of the kneaded product can be obtained as a liquid dispersion using a sand mill filled with beads of zirconia, or the like, for example. Note that at this time, a cross-linking agent can be mixed in according to need.

The magnetic coating material thus obtained is applied to a peelable support using a table coater, a bar coater, or the like. In one example, the peelable support is a 38 $\mu$m-thick polyethylene terephthalate (PET) sheet that has been subjected to a peeling treatment by silicone coating.

The magnetic coating material in a wet state is dried at 80°C and calendered with a predetermined temperature and pressure using a calender to form an electromagnetic-wave absorbing layer on the support.

In one example, by applying the magnetic coating material in a thickness of 1 mm in a wet state on the support, it is possible to obtain an electromagnetic-wave absorbing layer having a thickness of 400 $\mu$m after drying and a thickness of 300 $\mu$m after calendering.

In this manner, even if fine epsilon iron oxide powder on the order of nm is used as the electromagnetic-wave absorbing material, it is possible to form an electromagnetic-wave absorbing layer in a state in which the epsilon iron oxide powder is favorably dispersed in the resin binder.

Industrial Applicability

The electromagnetic-wave absorbing sheet disclosed in the present application is useful as an electromagnetic-wave absorbing sheet that absorbs electromagnetic waves in a high frequency band in or above a millimeter-wave band, and has flexibility.

Description of Reference Numerals

1      Electromagnetic-wave absorbing layer
1a     Epsilon iron oxide (electromagnetic-wave absorbing material)
1b     Binder
2      Adhesive layer (dielectric layer)
3      Reflective layer

**Claims**

1.  An electromagnetic-wave absorbing sheet comprising:

    an electromagnetic-wave absorbing layer (1) that includes a particulate electromagnetic-wave absorbing material (1a) and a rubber binder (1b); and
    a dielectric layer (2) that contains a dielectric and is arranged on a back surface of the electromagnetic-wave absorbing layer (1),
    **characterized in that** the electromagnetic-wave absorbing material (1a) is a magnetic iron oxide that magnetically resonates in a frequency band in or above a millimeter-wave band, and
    the dielectric layer (2) contains no conductive powder, is non-magnetic and has flexibility, a real part of a complex relative permittivity of the dielectric layer (2) is 2 or more and 6 or less, and the dielectric layer (2) has a thickness of 10 $\mu$m or more and 100 $\mu$m or less.

2.  The electromagnetic-wave absorbing sheet according to claim 1, wherein a reflective layer (3) that reflects electromagnetic waves that have passed through the electromagnetic-wave absorbing layer (1) and the dielectric layer (2) is formed on a back surface of the dielectric layer (2).

3.  The electromagnetic-wave absorbing sheet according to claim 1 or 2, wherein the electromagnetic-wave absorbing material (1a) is epsilon iron oxide or strontium ferrite.

4.  The electromagnetic-wave absorbing sheet according to claim 1 or 2, wherein the electromagnetic-wave absorbing material (1a) is epsilon iron oxide, and a portion of Fe sites of the epsilon iron oxide are substituted with trivalent metal atoms.

5.  The electromagnetic-wave absorbing sheet according to any one of claims 1 to 4, wherein the dielectric layer (2) is formed as a stacked body with two or more layers.

6.  The electromagnetic-wave absorbing sheet according to any one of claims 1 to 5, wherein the dielectric layer (2) has adhesiveness.

**Patentansprüche**

1. Elektromagnetische Wellen absorbierende Folie, mit:

   einer elektromagnetische Wellen absorbierenden Schicht (1), die ein partikelförmiges elektromagnetische Wellen absorbierendes Material (1a) und einen Kautschuk-Binder (1b) enthält; und
   einer dielektrischen Schicht (2), die ein Dielektrikum enthält und an einer Rückfläche der elektromagnetische Wellen absorbierenden Schicht (1) angeordnet ist,
   **dadurch gekennzeichnet, dass** das elektromagnetische Wellen absorbierende Material (1a) ein magnetisches Eisenoxid ist, das in einem Frequenzband in oder oberhalb eines Millimeterwellenbands magnetisch schwingt, und
   die dielektrische Schicht (2) kein leitfähiges Pulver enthält, nicht-magnetisch ist und Flexibilität aufweist, ein Realteil einer komplexen relativen Permittivität der dielektrischen Schicht (2) 2 oder mehr und 6 oder weniger beträgt, und die dielektrische Schicht (2) eine Dicke von 10 $\mu$m oder mehr und 100 $\mu$m oder weniger aufweist.

2. Elektromagnetische Wellen absorbierende Folie gemäß Anspruch 1, wobei eine reflektive Schicht (3), die elektromagnetische Wellen reflektiert, die durch die elektromagnetische Wellen absorbierende Schicht (1) und die dielektrische Schicht (2) hindurchgetreten sind, auf einer Rückfläche der dielektrischen Schicht (2) gebildet ist.

3. Elektromagnetische Wellen absorbierende Folie gemäß Anspruch 1 oder 2, wobei das elektromagnetische Wellen absorbierende Material (1a) ein epsilon-Eisenoxid oder Strontiumferrit ist.

4. Elektromagnetische Wellen absorbierende Folie gemäß Anspruch 1 oder 2, wobei das elektromagnetische Wellen absorbierende Material (1a) ein epsilon-Eisenoxid ist, und ein Teil der Fe-Plätze des epsilon-Eisenoxids mit trivalenten Metallatomen substituiert ist.

5. Elektromagnetische Wellen absorbierende Folie gemäß einem der Ansprüche 1 bis 4, wobei die dielektrische Schicht (2) als Stapelkörper mit zwei oder mehr Schichten gebildet ist.

6. Elektromagnetische Wellen absorbierende Folie gemäß einem der Ansprüche 1 bis 5, wobei die dielektrische Schicht (2) Klebrigkeit aufweist.

**Revendications**

1. Feuille d'absorption d'ondes électromagnétiques, comprenant :

   une couche absorbant les ondes électromagnétiques (1) qui comporte un matériau particulaire absorbant les ondes électromagnétiques (1a) et un liant en caoutchouc (1b) ; et une couche diélectrique (2) contenant un diélectrique et disposée sur une surface arrière de la couche absorbant les ondes électromagnétiques (1),
   **caractérisée en ce que** le matériau absorbant les ondes électromagnétiques (1a) est un oxyde de fer magnétique qui résonne magnétiquement dans une bande de fréquence égale ou supérieure à une bande d'ondes millimétriques, et
   la couche diélectrique (2) ne contient pas de poudre conductrice, n'est pas magnétique et est flexible, une partie réelle d'une permittivité relative complexe de la couche diélectrique (2) est égale ou supérieure à 2 et inférieure ou égale à 6, et la couche diélectrique (2) a une épaisseur égale ou supérieure à 10 $\mu$m et inférieure ou égale à 100 $\mu$m.

2. Feuille d'absorption d'ondes électromagnétiques selon la revendication 1, dans laquelle une couche réfléchissante (3) qui réfléchit les ondes électromagnétiques ayant traversé la couche absorbant les ondes électromagnétiques (1) et la couche diélectrique (2) est formée sur une surface arrière de la couche diélectrique (2).

3. Feuille d'absorption d'ondes électromagnétiques selon la revendication 1 ou 2, dans laquelle le matériau d'absorption d'ondes électromagnétiques (1a) est de l'oxyde de fer d'Epsilon ou du ferrite de strontium.

4. Feuille d'absorption d'ondes électromagnétiques selon la revendication 1 ou 2, dans laquelle le matériau d'absorption d'ondes électromagnétiques (1a) est de l'oxyde de fer d'Epsilon, et une partie des sites Fe de l'oxyde de fer d'Epsilon sont remplacés par des atomes de métal trivalent.

**5.** Feuille d'absorption d'ondes électromagnétiques selon l'une quelconque des revendications 1 à 4, dans laquelle la couche diélectrique (2) est formée d'un corps empilé avec deux couches ou plus.

**6.** Feuille d'absorption d'ondes électromagnétiques selon l'une quelconque des revendications 1 à 5, dans laquelle la couche diélectrique (2) a une adhérence.

FIG. 1

FIG. 2

FIG. 3A

FIG. 3B

FIG. 4

FIG. 5

FIG. 6

FIG. 7

FIG. 8

FIG. 9

FIG. 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008060484 A
- JP 2016135737 A
- JP 2011233834 A
- US 2016113162 A1
- JP 2007019287 A